# EUROPÄISCHE PATENTSCHRIFT

(11) **EP 3 513 634 B1**
(45) Veröffentlichungstag und Bekanntmachung des Hinweises auf die Patenterteilung: **28.07.2021**
(21) Anmeldenummer: 17772008.3
(22) Anmeldetag: 13.09.2017
(51) Int. Cl.: H05K 5/00, H05K 9/00, H05K 1/02

(54) **GEHÄUSEKONTAKTIERUNG EINES STEUERGERÄTES**
HOUSING CONTACTING SYSTEM OF A CONTROL DEVICE
MISE EN CONTACT BOÎTIER D'UN DISPOSITIF DE COMMANDE

(30) Priorität: 15.09.2016 DE 102016117331
(43) Veröffentlichungstag der Anmeldung: 24.07.2019
(73) Patentinhaber: KNORR-BREMSE Systeme für Nutzfahrzeuge GmbH, 80809 München (DE)
(72) Erfinder: MÜLLER, Elena, 90453 Nürnberg (DE); BEHRENDT, Norbert, 90547 Stein (DE); LECHNER, Klaus, 91362 Pretzfeld (DE); POHLEY, Karin, 90489 Nürnberg (DE)
(86) Internationale Anmeldenummer: PCT/EP2017/073003
(87) Internationale Veröffentlichungsnummer: WO 2018/050685

(56) Entgegenhaltungen:
- DE-A1- 10 205 816
- JP-A- 2003 347 755
- US-A1- 2009 298 357

## Beschreibung

Die vorliegende Erfindung bezieht sich auf eine Gehäusekontaktierung eines Steuergerätes und insbesondere auf eine EMV-Kontaktierung (EMV=elektromagnetisch Verträglichkeit) in einem Kunststoffgehäuse.

Steuergeräte erfüllen in Fahrzeugen häufig sicherheitsrelevante Funktionen. Eine einwandfreie Funktion der elektronischen Komponenten in den Steuergeräten ist daher wichtig. Wenn die Steuergeräte in Kunststoffgehäusen untergebracht sind, können elektromagnetische Störsignale direkt ins Innere zu den elektronischen Komponenten gelangen. Die elektronischen Komponenten sind beispielsweise auf einer Leiterplatte angeordnet und die vorgesehene EMV-Kontaktierung (z.B. über einen ausreichenden Massekontakt, Abschirmung, etc.) soll verhindern, dass die elektronischen Komponenten negativ durch die elektromagnetische Störsignal beeinträchtigt werden. Somit ist eine zuverlässige EMV-Kontaktierung für die einwandfreie Funktionsweise des Steuergerätes sehr wichtig. Konventionelle Gehäuseeinheiten sind in der JP2003 347 755 (für ein Mobiltelephon), in DE 102 05 816 (für ein elektrisches Gerät) und in US 2009/298357 A1 mit einem Massekontakt offenbart

Ein bekanntes Problem in Fahrzeugen besteht jedoch darin, dass häufige Temperaturänderungen und Vibrationen dazu führen, dass elektrische Kontakte und insbesondere die EMV-Kontaktierung über einen längeren Zeitraum sich lösen oder lockern können und ein Wackelkontakt entsteht. In konventionellen Steuergeräten erfolgt eine direkte Kontaktierung der beispielhaften Leiterplatte über eine Verschraubung auf einem Blech, das beispielsweise der Befestigung des Steuergerätes dient. Eine solche Verschraubung kann sich durch die Temperaturänderungen und Vibrationen mit der Zeit lösen und ist auf Dauer häufig nicht zuverlässig.

Daher besteht ein Bedarf nach alternativen Lösungen, um eine zuverlässige Kontaktierung der elektronischen Komponenten in dem Steuergerät, insbesondere bei der Verwendung in Fahrzeugen, sicherzustellen.

Die zuvor genannten Probleme werden durch eine Gehäusekontaktierung nach Anspruch 1, ein Bremssteuergerät nach Anspruch 5, ein Nutzfahrzeug nach Anspruch 6 oder ein Verfahren zum Kontaktieren nach Anspruch 7 gelöst. Die abhängigen Ansprüche 2 bis 4 beziehen sich auf vorteilhafte Weiterbildungen der Gehäusekontaktierung nach Anspruch 1.

Die vorliegende Erfindung bezieht sich auf eine Gehäusekontaktierung eines Steuergerätes, das für den Einsatz in Fahrzeugen, insbesondere Nutzfahrzeugen, geeignet ist. Die Gehäusekontaktierung umfasst einen Gehäusedeckel und ein Bodenelement, die zusammen einen Innenraum definieren, in dem eine Leiterplatte mit einer Vorderseite und einer Rückseite angeordnet ist, wobei auf der Rückseite eine leitfähige Oberflächenschicht ausgebildet ist. Gehäusekontaktierung umfasst weiter ein Federelement, welches zumindest teilweise elektrisch leitfähig ist und unter einer (Feder-) Vorspannung zwischen der leitfähigen Oberflächenschicht und der Bodenplatte angeordnet, um eine Rückseitenkontaktierung der Leiterplatte zu bewirken, wobei das Federelement auf dem Bodenelement zumindest hinsichtlich einer lateralen Bewegung parallel zur Leiterplatte fest fixiert ist und lose auf der Rückseite der Leiterplatte aufliegt und die Leiterplatte auf der Rückseite eine verzinnte Oberfläche also Oberflächenschicht aufweist.

Der Gehäusedeckel soll alle Gehäuseabschnitte umfassen, die abgesehen von einem Bodenelement das Gehäuse des Steuergerätes bilden. Ohne die Erfindung darauf einzuschränken kann der Gehäusedeckel beispielsweise eine topfartige Form aufweisen, die auf das Bodenelement aufgesetzt wird, um die in dem Innenraum angeordneten elektronischen Komponenten zu schützen. Die Vorderseite und Rückseite der Leiterplatte definieren beispielsweise zwei gegenüberliegende Seiten der Leiterplatte, wobei die Vorderseite beispielsweise dadurch definiert werden kann, dass von dieser Seite die elektronischen Komponenten auf die Leiterplatte aufgesetzt sind und die Rückseite die entsprechenden Kontaktierungsstrukturen zwischen den einzelnen elektronischen Bauelementen umfasst. Die Vorder- und Rückseite können jedoch auch anders definiert sein, beispielweise können zumindest ein Teil der elektronischen Bauelemente von der Rückseite auf die Leiterplatte aufsetzbar sein. Für den Gegenstand der vorliegenden Erfindung ist die genaue Position der elektronischen Bauteile nicht wichtig, vielmehr soll die Rückseite lediglich dadurch definiert sein, dass von dieser Seite eine EMV-Kontaktierung (oder auch eine Massekontaktierung) möglich ist, nicht aber zwingend erforderlich ist.

Bei weiteren Ausführungsbeispielen umfasst der Gehäusedeckel ein Kunststoffmaterial und das Bodenelement ein Metall oder einen Gusswerkstoff.

Bei weiteren Ausführungsbeispielen bildet die Rückseitenkontaktierung der Leiterplatte eine EMV-Kontaktierung oder einen Massekontakt.

Erfindungsgemäß umfasst die Leiterplatte eine verzinnte Oberfläche als Oberflächenschicht, die teilweise oder ganzflächig auf der Rückseite ausgebildet sein kann

Optional kann das Federelement an der Rückseite der Leiterplatte befestigt sein und unter einer Federvorspannung auf dem Bodenelement aufliegen. Das Federelement kann beispielsweise eine Blattfeder oder eine Spiralfeder aufweisen. Die Leiterplatte oder das Bodenelement kann eine Befestigung für das Federelement aufweisen, wobei die Befestigung eine laterale Verschiebung parallel zur Leiterplatte auf ihrer Rückseite verhindert. Eine Bewegung senkrecht zur Leiterplatte kann jedoch möglich sein, da in diese Richtung die Federkraft wirkt und eine Federspannung zwischen der Leiterplatte und dem Bodenelement für eine Fixierung sorgt. Optional kann sie jedoch auch in diese Richtung fixiert sein.

Die vorliegende Erfindung bezieht sich auch auf ein Bremssteuergerät mit einer Gehäusekontaktierung, wie es zuvor beschrieben wurde. Außerdem bezieht sich die vorliegende Erfindung auf ein Nutzfahrzeug mit dem Bremssteuergerät.

Somit lösen die Ausführungsbeispiele die genannten technischen Probleme dadurch, dass ein Federkontakt vorgesehen ist, der ein Bodenelement mit einer Seite der Leiterplatte verbindet und die Federkraft eine permanente Kontaktierung, selbst bei Temperaturänderungen oder Vibrationen sicherstellt.

Im Gegensatz zu konventionellen Gehäusekontaktierungen, bei denen eine direkte Kontaktierung der Leiterplatte beispielsweise auf dem Bodenelement über eine Schraube erfolgt, weisen Ausführungsbeispiele die folgenden Vorteile auf: ein einfaches und kostengünstiges Design wird ermöglicht, die Leiterplatte kann in ein Kunststoffgehäuse geschraubt sein, wobei die Federwirkung immer dafür sorgt, dass ein elektrischer Kontakt zwischen der Leiterplatte und dem Bodenelement vorliegt. Somit brauchen Toleranzen nicht berücksichtigt zu werden, da die Federkraft automatisch Abweichungen zwischen der Entfernung zwischen dem Bodenelement und der Leiterplatte ausgleicht.

Die Ausführungsbeispiele der vorliegenden Erfindung werden besser verstanden mit der folgenden detaillierten Beschreibung und den beiliegenden Zeichnungen der unterschiedlichen Ausführungsbeispiele, die jedoch nicht so verstanden werden sollten, dass sie die Offenbarung auf die spezifischen Ausführungsformen einschränkt, sondern lediglich der Erklärung und dem Verständnis dienen.
- Fig. 1: zeigt ein Gehäuse für ein Steuergerät mit einer Gehäusekontaktierung gemäß einem Ausführungsbeispiel der vorliegenden Erfindung.
- Fig. 2: zeigt ein Flussdiagramm für ein Verfahren zu Herausbildung einer EMV-Kontaktierung in einem Kunststoffgehäuse.

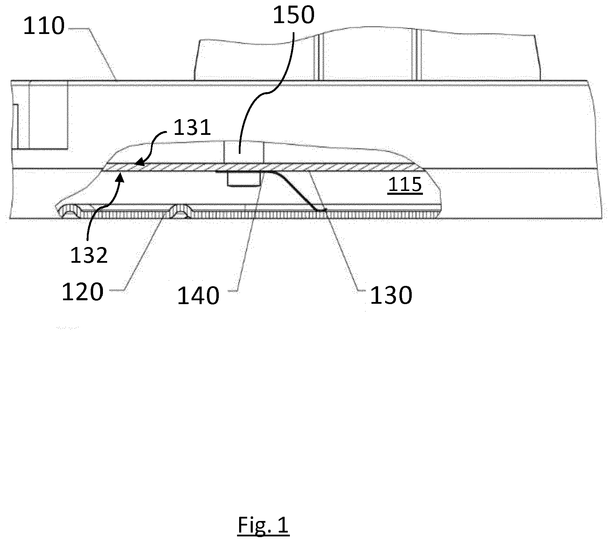

**Fig. 1** zeigt ein Gehäuse mit einer Gehäusekontaktierung nach einem Ausführungsbeispiel der vorliegenden Erfindung. Das Gehäuse ist geeignet für ein Steuergerät eines Fahrzeuges und umfasst ein Gehäusedeckel 110, ein Bodenelement 120 und eine Leiterplatte 130 mit einer Vorderseite 131 und einer Rückseite 132. Der Gehäusedeckel 110 und das Bodenelement 120 definieren einen Innenraum 115, in dem die Leiterplatte 130 angeordnet ist. Die Leiterplatte 130 kann beispielsweise über ein Halteelement 150 an dem Gehäusedeckel 110 fixiert sein. Zwischen der Rückseite 132 der Leiterplatte 130 und dem Bodenelement 120 ist ein Federkontakt über ein Federelement 140 ausgebildet. Das Federelement 140 kann beispielsweise eine Blattfeder umfassen, die an einer Rückseite 132 der Leiterplatte 130 fixiert ist und eine Federkraft auf das Bodenelement 120 ausübt, ohne dass das Federelement 140 an dem Bodenelement 120 befestigt sein muss. Sie braucht nur aufzuliegen. Beispielsweise kann das Federelement 140 derart an der Leiterplatte 130 befestigt werden, dass eine laterale Verschiebung parallel zur Leiterplatte 130 unmöglich ist - jedoch kann das Federelement 140 (z.B. beim Abnehmen des Bodenelementes 120) in senkrechter Richtung von der Leiterplatte 130 entfernt werden (keine Fixierung des Federelementes 140 senkrecht zur Leiterplatte).

Erfingsgemäß ist es ebenfalls vorgesehen, dass das Federelement 140 auf dem Bodenelement 120 zumindest hinsichtlich der lateralen Bewegung parallel zur Leiterplatte fixiert ist und lose auf einer Rückseite 132 der Leiterplatte 130 aufliegt (d.h. eine Umkehrung der oben genannten Anordnung). Außerdem kann das Federelement 140 optional fest an der Rückseite 132 der Leiterplatte 130 oder fest auf dem Bodenelement 120 befestigt sein (z.B. daran gelötet oder geschraubt oder vernietet sein).

Außerdem kann das Federelement 140 als Blattfeder oder auch als Spiralfeder ausgebildet sein. Die vorliegende Erfindung ist jedoch nicht auf spezielle Federn eingeschränkt. Vielmehr können auch andere Federtypen genutzt werden, solange sie eine Vorspannung zwischen dem Bodenelement 120 und der Leiterplatte 130 bewirken. Außerdem kann die Rückseite und Vorderseite 131, 132 der Leiterplatte 130 vertauscht sein. Beispielsweise kann dazu das Halteelement 140 ein leitfähiges Material aufweisen, welches eine Durchkontaktierung durch die Leiterplatte 130 und somit einen elektrischen Kontakt zur gegenüberliegenden Seite bewirkt.

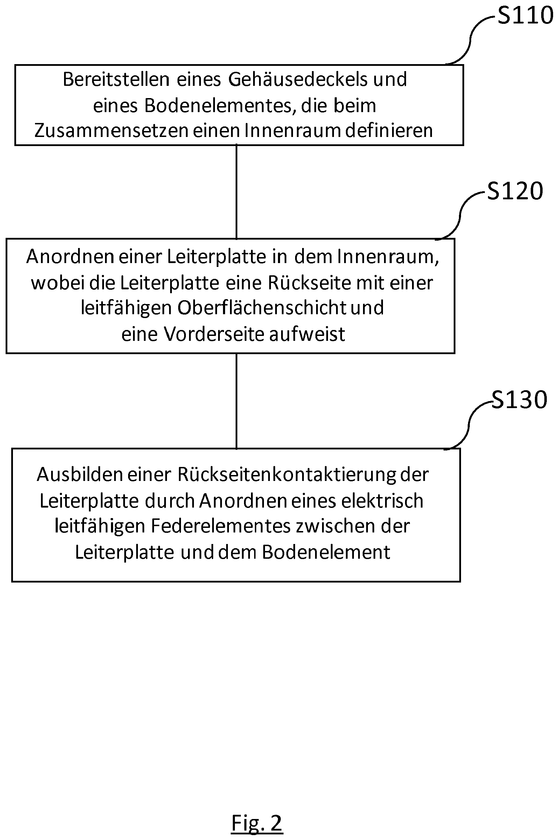

Der Gehäusedeckel 110 kann beispielsweise ein Kunststoffgehäuse sein. Das Bodenelement 120 kann beispielsweise ein Metall oder ein Gussmaterial aufweisen oder als Blech ausgebildet sein, das beispielweise zur Befestigung des Steuergerätes dient (z.B. an einem Fahrzeugrahmen). Das Federelement 140 kann eine zuverlässige EMV-Kontaktierung sicherstellen, wozu die Leiterplatte 130 auf der Rückseite 132 beispielsweise eine verzinnte Oberfläche aufweisen kann, die ein EMV-Land definiert. **Fig. 2** zeigt ein Flussdiagramm für ein Verfahren zur EMV-Kontaktierung einer Leiterplatte in einem Gehäuse. Das Verfahren umfasst die Schritte: Bereitstellen S110 eines Gehäusedeckels 110 und eines Bodenelementes 120, die beim Zusammensetzen einen Innenraum 115 definieren, und Anordnen S120 einer Leiterplatte 130 in dem Innenraum 115, wobei die Leiterplatte 130 eine Vorderseite und eine Rückseite mit einer leitfähigen Oberflächenschicht aufweist. Außerdem umfasst das Verfahren den Schritt eines Ausbildens S130 einer Rückseitenkontaktierung der Leiterplatte 130 durch ein Federelement 140, welches elektrisch leitfähig ist und unter einer (Feder-) Vorspannung zwischen der leitfähigen Oberflächenschicht und der Bodenplatte 120 angeordnet wird.

### BEZUGSZEICHENLISTE

- 110: Gehäusedeckel
- 120: Bodenelement
- 115: Innenraum
- 130: Leiterplatte
- 131: Vorderseite
- 132: Rückseite
- 140: Federelement
- 150: Halteelement

## Patentansprüche

1. Gehäusekontaktierung eines Steuergerätes,
**folgendes umfassend:**
- einen Gehäusedeckel (110) und ein Bodenelement (120), die zusammen einen Innenraum (115) des Steuergerätes definieren; und
- eine Leiterplatte (130) mit einer Vorderseite (131) und einer Rückseite (132), wobei auf der Rückseite (132) eine leitfähige Oberflächenschicht ausgebildet ist und die Leiterplatte (130) in dem Innenraum (115) angeordnet ist, **gekennzeichnet durch**:
- ein Federelement (140), welches zumindest teilweise elektrisch leitfähig ist und unter einer Federvorspannung zwischen der leitfähigen Oberflächenschicht und dem Bodenelement (120) angeordnet ist, um eine Rückseitenkontaktierung der Leiterplatte (130) zu bewirken, wobei das Federelement (140) auf dem Bodenelement (120) zumindest hinsichtlich einer lateralen Bewegung parallel zur Leiterplatte fest fixiert ist und lose auf der Rückseite (132) der Leiterplatte (130) aufliegt und die Leiterplatte (130) auf der Rückseite (132) eine verzinnte Oberfläche also Oberflächenschicht aufweist.

2. Gehäusekontaktierung nach Anspruch 1,
**dadurch gekennzeichnet, dass**
der Gehäusedeckel (110) ein Kunststoffmaterial und das Bodenelement (120) ein Metall oder einen Gusswerkstoff aufweist.

3. Gehäusekontaktierung nach Anspruch 1 oder Anspruch 2,
**dadurch gekennzeichnet, dass**
die Rückseitenkontaktierung der Leiterplatte (130) eine EMV-Kontaktierung oder einen Massekontakt bildet.

4. Gehäusekontaktierung nach einem der vorhergehenden Ansprüche,
**dadurch gekennzeichnet, dass**
das Federelement (140) eine Blattfeder oder eine Spiralfeder aufweist und das Bodenelement (120) eine Befestigung für das Federelement (140) aufweist.

5. Bremssteuergerät mit einer Gehäusekontaktierung nach einem der Ansprüche bis 1 bis 4.

6. Nutzfahrzeug mit einem Bremssteuergerät nach Anspruch 5.

7. Verfahren zur EMV-Kontaktierung einer Leiterplatte in einem Steuergerät,
**folgendes umfassend:**
- Bereitstellen (S110) eines Gehäusedeckels (110) und eines Bodenelementes (120), die beim Zusammensetzen einen Innenraum (115) des Steuergerätes definieren;
**gekennzeichnet durch:**
- Anordnen (S120) einer Leiterplatte (130) in dem Innenraum (115), wobei die Leiterplatte (130) eine Rückseite (132) mit einer leitfähigen, verzinnten Oberflächenschicht und eine Vorderseite (131) aufweist; und
- Ausbilden (S130) einer Rückseitenkontaktierung der Leiterplatte (130) durch ein Federelement (140), welches zumindest teilweise elektrisch leitfähig ist und unter einer Federvorspannung zwischen der leitfähigen Oberflächenschicht und der Bodenplatte (120) angeordnet wird, wobei das Federelement (140) auf dem Bodenelement (120) zumindest hinsichtlich einer lateralen Bewegung parallel zur Leiterplatte fest fixiert ist und lose auf der Rückseite (132) der Leiterplatte (130) aufliegt.

## Claims

1. Housing contacting system of a control device,
**comprising the following:**
- a housing cover (110) and a base element (120) which together define an interior (115) of the control device; and
- a printed circuit board (130) having a front side (131) and a rear side (132), wherein a conductive surface layer is formed on the rear side (132) and the printed circuit board (130) is arranged in the interior (115),
**characterized by**:
- a spring element (140) which is at least partially electrically conductive and is arranged between the conductive surface layer and the base element (120) under spring prestress in order to implement rear-side contacting of the printed circuit board (130), wherein the spring element (140) is firmly fixed on the base element (120) at least in respect of lateral movement parallel to the printed circuit board and rests loosely on the rear side (132) of the printed circuit board (130), and the printed circuit board (130) on the rear side (132) has a tin-plated surface i.e. surface layer.

2. Housing contacting system according to Claim 1,
**characterized in that**
the housing cover (110) contains a plastic material and the base element (120) contains a metal or a cast material.

3. Housing contacting system according to Claim 1 or Claim 2,
**characterized in that**
the rear-side contacting of the printed circuit board (130) forms EMC contacting or ground contact.

4. Housing contacting system according to one of the preceding claims,
**characterized in that**
the spring element (140) has a leaf spring or a helical spring, and the base element (120) has a fastening system for the spring element (140).

5. Brake control device comprising a housing contacting system according to one of Claims to 1 to 4.

6. Utility vehicle comprising a brake control device according to Claim 5.

7. Method for EMC contacting a printed circuit board in a control device,
**comprising the following:**
- providing (S110) a housing cover (110) and a base element (120) which, when put together, define an interior (115) of the control device;
**characterized by:**
- arranging (S120) a printed circuit board (130) in the interior (115), wherein the printed circuit board (130) has a rear side (132) with a conductive, tin-plated surface layer and has a front side (131); and
- forming (S130) rear-side contacting of the printed circuit board (130) by a spring element (140) which is at least partially electrically conductive and is arranged between the conductive surface layer and the base plate (120) under spring prestress, wherein the spring element (140) is firmly fixed on the base element (120) at least in respect of lateral movement parallel to the printed circuit board and rests loosely on the rear side (132) of the printed circuit board (130).

## Revendications

1. Mise en contact par boîtier d'un appareil de commande, **comprenant ce qui suit :**
- un couvercle (110) de boîtier et un élément (120) de fond, qui définissent ensemble un espace (115) intérieur de l'appareil de commande ;
- une plaquette (130) à circuit imprimé ayant une face (131) avant et une face (132) arrière, une couche superficielle conductrice étant constituée sur la face (132) arrière et la plaquette (130) à circuit imprimé étant disposée dans l'espace (115) intérieur,
**caractérisée par** :
- un élément (140) de ressort, qui est conducteur de l'électricité au moins en partie et qui est disposé, avec une pré-contrainte de ressort, entre la couche superficielle conductrice et l'élément (120) de fond, pour provoquer une mise en contact par la face arrière de la plaquette (130) à circuit imprimé, l'élément (140) de ressort étant immobilisé fixement sur l'élément (120) de fond, au moins en ce qui concerne un déplacement latéral parallèlement à la plaquette à circuit imprimé, et s'appliquant de manière lâche sur la face (132) arrière de la plaquette (130) à circuit imprimé et la plaquette (130) à circuit imprimé ayant sur la face (132) arrière une surface étamée, donc une couche superficielle.

2. Mise en contact par boîtier suivant la revendication 1,
**caractérisée en ce que**
le couvercle (110) du boîtier comprend une matière plastique et l'élément (120) de fond un métal ou un matériau de coulée.

3. Mise en contact par boîtier suivant la revendication 1 ou la revendication 2,
**caractérisée en ce que**
le contact par la face arrière de la plaquette (130) à circuit imprimé forme une mise en contact compatible électromagnétiquement ou un contact de masse.

4. Mise en contact par boîtier suivant une des revendications précédentes,
**caractérisée en ce que**
l'élément (140) de ressort est un ressort à lame ou un ressort hélicoïdal et l'élément (120) de fond a une fixation de l'élément (140) de ressort.

5. Appareil de commande de frein comprenant une mise en contact, par boîtier suivant l'une des revendications 1 à 4.

6. Véhicule utilitaire ayant un appareil de commande de frein suivant la revendication 5.

7. Procédé de mise en contact compatible électromagnétiquement d'une plaquette à circuit imprimé d'un appareil de commande,
**comprenant ce qui suit :**
- on se procure (S110) un couvercle (110) de boîtier et un élément (120) de fond, qui, mis ensemble, définissent un espace (120) intérieur de l'appareil de commande ;
**caractérisé en ce que :**
- on met (S120) une plaquette (130) à circuit imprimé dans l'espace (115) intérieur, la plaquette (130) à circuit imprimé ayant une face (132) arrière ayant une couche superficielle conductrice étamée et une face (131) avant ;
- on constitue (S130) une mise en contact par la face arrière de la plaquette (130) à circuit imprimé, par un élément (130) de ressort, qui est conducteur de l'électricité, au moins en partie, et qui est disposé avec pré-contrainte du ressort entre la couche superficielle conductrice et la plaque (120) de fond, l'élément (140) de ressort étant immobilisé fixement sur l'élément (120) de fond, au moins en ce qui concerne un déplacement latéral parallèlement à la plaquette à circuit imprimé, et s'appliquant de manière lâche sur la face (132) arrière de la plaquette (130) à circuit imprimé.
